# EUROPEAN PATENT APPLICATION

(11) **EP 4 693 417 A1**
(43) Date of publication of application: **11.02.2026**
(21) Application number: 24777497.9
(22) Date of filing: 31.01.2024
(51) Int. Cl.: H01L 31/074, H01L 31/18, H01L 31/0216, H01L 31/0224

(54) **SOLAR CELL AND MANUFACTURING METHOD THEREFOR**

(30) Priority: 29.03.2023 CN 202310322839
(71) Applicant: Ja Solar Technology Yangzhou Co., Ltd., Yangzhou, Jiangsu 225131 (CN)
(72) Inventor: CHEN, Xiaoye, Yangzhou, Jiangsu 225131 (CN); ZHANG, Junbing, Yangzhou, Jiangsu 225131 (CN); JIANG, Xiulin, Yangzhou, Jiangsu 225131 (CN)
(74) Representative: Sun, Yiming
(86) International application number: PCT/CN2024/074933
(87) International publication number: WO 2024/198703

(57) **Abstract**

Provided are a solar cell and a manufacturing method for same. At least some embodiments of the present disclosure provide a solar cell, comprising : a silicon substrate; a first passivation layer provided on a first side of the silicon substrate; and a first doped conductive layer provided on the first passivation layer, such that the first passivation layer is located between the silicon substrate and the first doped conductive layer. The first doped conductive layer contains an oxygen element and a carbon element, and contains a Si-O chemical bond and a Si-C chemical bond.

## Description

The present disclosure claims the priority and benefits of the Chinese Patent Applications No. 202310322839.6, which was filed on March 29, 2023, the disclosure of which is incorporated herein by reference in its entirety as part of the present disclosure.

### TECHNICAL FIELD

The present disclosure relates to a solar cell unit and a manufacturing method of a solar cell unit.

### BACKGROUND

Crystalline silicon-based heterojunction cell is a semiconductor device that can convert solar energy into electric power output. Generally, a heterojunction cell is prepared by using an n-type silicon substrate, the heterojunction cell includes a silicon substrate, two passivation layers on both sides of the silicon substrate, and doped conductive layers on the passivation layers on both sides respectively.

The preparation process includes: depositing hydrogenated amorphous silicon layers on both side surfaces of the textured silicon substrate, respectively depositing phosphorus and boron doped silicon layers on the surfaces of the hydrogenated amorphous silicon layers on both sides, depositing transparent conductive ITO layers on the surfaces of the doped silicon layers, and finally forming electrodes on the ITO layers. The Heterojunction cell has many advantages: high battery efficiency, no attenuation, few process steps, low energy consumption (the temperature is below 300 degrees) and the like. At present, the main factor limiting the large-scale market occupation of heterojunction cells is that the preparation cost is slightly higher than other photovoltaic cells. Therefore, it is still the development direction of Heterojunction cell to continuously improve the photoelectric conversion efficiency and improve the cost performance of the heterojunction cell.

### SUMMARY

At least some embodiments of the present disclosure provide a solar cell unit, which includes: a silicon substrate; a first passivation layer, disposed on a first side of the silicon substrate; and a first doped conductive layer, disposed on the first passivation layer so that the first passivation layer is located between the silicon substrate and the first doped conductive layer., The first doped conductive layer comprises carbon element and oxygen element, and comprises a Si-O chemical bond and a Si-C chemical bond.

For example, in some embodiments, a total molar content of the carbon element and the oxygen element is 20-30%.

For example, in some embodiments, the first doped conductive layer comprises silicon element, oxygen element, carbon element, and hydrogen element, and a molar content ratio of the carbon element is 3-15%.

For example, in some embodiments, the carbon element exists by forming the Si-C chemical bond, a C-C chemical bond, a C-O chemical bond and a C-H chemical bond, and molar content ratios of the Si-C chemical bond, the C-C chemical bond, the C-O chemical bond and the C-H chemical bond in a total carbon content are 40-60%, 30-50%, 5-18% and 2-10%, respectively.

For example, in some embodiments, the first doped conductive layer comprises silicon element, oxygen element, carbon element and hydrogen element, and a molar content ratio of the oxygen element is 10-30%.

For example, in some embodiments, the oxygen element exists by forming the Si-O chemical bond, a C-O chemical bond and a P-O chemical bond, and molar content ratios of the Si-O chemical bond, the C-O chemical bond and the P-O chemical bond in the total oxygen content are 70-90%, 6-18% and 2-10%, respectively.

For example, in some embodiments, a band gap width of the first doped conductive layer is in a range of 1.9-2.4 eV.

For example, in some embodiments, a thickness of the first doped conductive layer is in a range of 6-14 nm.

For example, in some embodiments, in a direction toward the silicon substrate, a molar content of the carbon element in the first doped conductive layer gradually decreases, a molar content of the oxygen element in the first doped conductive layer gradually increases, and a molar content of a doping element in the first doped conductive layer gradually decreases.

For example, in some embodiments, a content of a doping element in the first doped conductive layer is in a range of 2×1018-3×1021 atoms per cubic centimeter.

For example, in some embodiments, at least a part of a silicon component of the first doped conductive layer is crystallized.

For example, in some embodiments, a crystallization rate of the first doped conductive layer is in a range of 40-70%.

For example, in some embodiments, the first doped conductive layer is a hydrogenated amorphous silicon layer in which crystallized silicon is embedded. That is, the first doped conductive layer is a microcrystalline silicon layer that is only partially crystallized.

For example, in some embodiments, in a direction toward the silicon substrate, a crystallization rate of the first doped conductive layer gradually decreases.

For example, in some embodiments, the first doped conductive layer is an n-type conductive layer and comprises silicon element, oxygen element, carbon element, hydrogen element and phosphorus element.

For example, in some embodiments, the silicon substrate is an n-type silicon substrate.

For example, in some embodiments, the first doped conductive layer is a p-type conductive layer and comprises silicon element, oxygen element, carbon element, hydrogen element and boron element.

For example, in some embodiments, the solar cell unit further includes: a second doped conductive layer disposed on the first doped conductive layer such that the first doped conductive layer is located between the first passivation layer and the second doped conductive layer.

For example, in some embodiments, a content of a doping element in the second doped conductive layer is in a range of 1019-1021 atoms per cubic centimeter.

For example, in some embodiments, the solar cell unit further includes: a second passivation layer, disposed on a second side of the silicon substrate; and a third doped conductive layer, disposed on the second passivation layer so that the second passivation layer is located between the silicon substrate and the third doped conductive layer. At least the first side is a light receiving side.

At least some embodiments of the present disclosure provide a manufacturing method of a solar cell unit, which includes: providing a silicon substrate; forming a first passivation layer on a first side of a silicon substrate; and forming a first doped conductive layer on the first passivation layer so that the first passivation layer is located between the silicon substrate and the first doped conductive layer. When forming the first doped conductive layer, oxygen-containing reaction gas and carbon-containing reaction gas are used, so that the first doped conductive layer comprises a Si-O chemical bond and a SiC chemical bond.

For example, in some embodiments, the oxygen-containing reaction gas is one or more selected from the group consisting of N2O, O2, CO2 and CO.

For example, in some embodiments, the carbon-containing reaction gas is one or more selected from the group consisting of CH4, C2H6, C3H10 and C2H4.

For example, in some embodiments, when forming first doped conductive layer, phosphine gas is used, so that the first doped conductive layer is doped with phosphorus.

For example, in some embodiments, when forming the first doped conductive layer, PH3 gas and SiH4 gas are used, and a flow ratio of the PH3 gas and the SiH4 gas is 0.02-0.1.

For example, in some embodiments, forming the first doped conductive layer by using a plasma enhanced chemical vapor deposition method, wherein a radio frequency power supply or a very high frequency power supply is used as a plasma excitation source, an energy density of an ion source is 100-600mW/cm2, a deposition pressure is 0.4-5Torr, and a deposition temperature is 130-230 °C.

### BRIEF DESCRIPTION OF DRAWINGS

Fig. 1 shows a part of a light receiving side of a solar cell unit;
Fig. 2 shows a part of a light receiving side of another solar cell unit;
Fig. 3 shows the influence of using gases of different oxygen-silicon ratios and gases of different carbon-silicon ratios on the phosphorus content in a microcrystalline silicon doped conductive layer when forming the microcrystalline silicon doped conductive layer;
Fig. 4 shows a schematic diagram of a solar cell unit according to an embodiment of the present disclosure;
Fig. 5 shows the values of the thickness and band gap width of four samples of doped conductive layers formed with different reaction gases;
Fig. 6 shows phosphorus doping concentrations in samples 3 and 4 in Fig. 5;
Figs. 7 and 8 respectively show the results of X-ray photoelectron spectroscopy (XPS) analysis of carbon element and silicon element in a first doped conductive layer of a solar cell unit according to an embodiment 1;
Fig. 9 shows a performance comparison of solar cell units according to a comparative example 1 and an embodiment 2.

### DETAILED DESCRIPTION

Hereinafter, a solar cell unit and a manufacturing method thereof according to embodiments of the present disclosure will be described in detail with reference to the drawings.

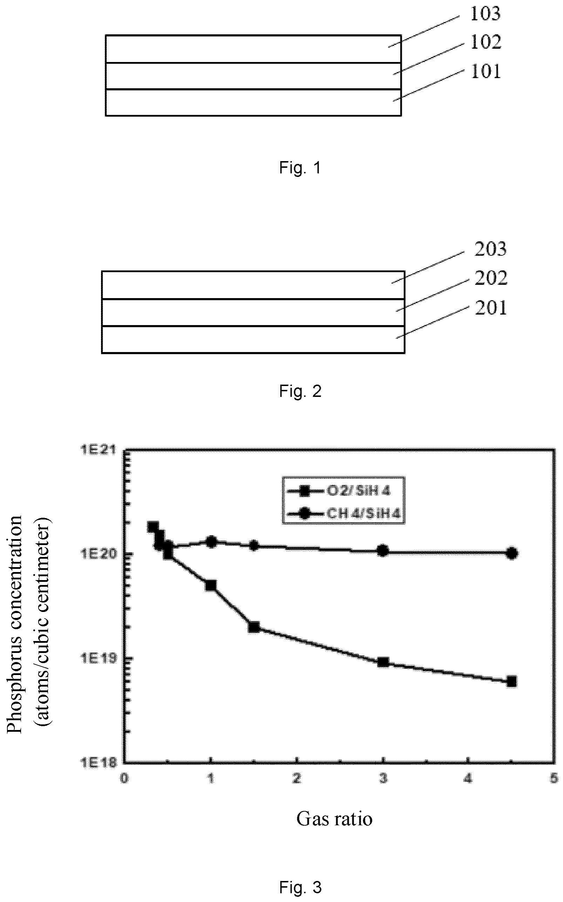

Fig. 1 shows a part of a light receiving side of a solar cell unit. The solar cell unit is a silicon-based heterojunction cell. As illustrated by Fig. 1, the solar cell unit includes a silicon substrate 101, an intrinsic hydrogenated amorphous silicon passivation layer 102 disposed on a surface of the silicon substrate 101, and an amorphous silicon doped conductive layer 103 deposited on the intrinsic hydrogenated amorphous silicon passivation layer 102. The inner intrinsic hydrogenated amorphous silicon passivation layer passivates a surface of the silicon substrate 101, and the outer amorphous silicon doped conductive layer 103 bends the energy band by its doping, thus completing the extraction and transmission of corresponding carriers. Because the band gap of amorphous silicon material is about 1.6-1.7eV, and it is a material similar to direct band gap material, the amorphous silicon layer has a strong absorption effect on short-band light. If the amorphous silicon doped conductive layer 103 is used on the light receiving side of the heterojunction cell, it will obviously lose current due to the absorption of light by the amorphous silicon doped conductive layer 103. It is an effective way to improve the conversion efficiency of the heterojunction cell by using a wide band gap material on the light receiving side to reduce light absorption.

Fig. 2 shows a part of a light receiving side of another solar cell unit. As illustrated by Fig. 2, the solar cell unit includes a silicon substrate 201, an intrinsic hydrogenated amorphous silicon passivation layer 202 disposed on a surface of the silicon substrate 201, and a microcrystalline silicon doped conductive layer 203 deposited on the intrinsic hydrogenated amorphous silicon passivation layer 202. At least a part of the amorphous silicon doped conductive layer is crystallized in the process of preparing the conductive layer to be transformed into the microcrystalline silicon doped conductive layer 203. In this way, at least a part of the direct band gap material is transformed into the indirect band gap material, which reduces the absorption of light, and at the same time, the crystallized microcrystalline silicon doped conductive layer 203 can also increase the concentration of doped atoms. This technology is called silicon thin film microcrystalline technology. For example, when the doped conductive layer is formed by plasma enhanced chemical vapor deposition (PECVD), the crystallization of the amorphous silicon doped conductive layer is realized by increasing the flow ratio of H2/SiH4, and the crystallization rate increases with the increase of the flow ratio of H2/SiH4. However, the band gap width of the crystallized microcrystalline silicon doped conductive layer 203 is close to that of crystalline silicon material, which will also increase light absorption. Further, when the microcrystalline silicon doped conductive layer 203 is deposited, oxygen element is introduced into the microcrystalline silicon doped conductive layer 203 by introducing oxygen-containing gas such as N2O, so that at least a part of the silicon element forms Si-O chemical bonds, so that the band gap width of the microcrystalline silicon doped conductive layer 203 can be increased.

Fig. 3 shows the influence of using gases of different oxygen-silicon ratios (O2/SiH4) and different carbon-silicon ratios (CH4/SiH4) on the phosphorus content in microcrystalline silicon doped conductive layer 203. The oxygen-silicon ratio and the carbon-silicon ratio of the gases can be generally regarded as the oxygen-silicon ratio and the carbon-silicon ratio in the microcrystalline silicon doped conductive layer 203. As illustrated by Fig. 3, with the increase of the content of oxygen element in microcrystalline silicon doped conductive layer 203, the content of doped elements (such as phosphorus and boron) in the conductive layer will gradually decrease. Excessive oxygen content is not conducive to the extraction and conduction of carriers by microcrystalline conductive layer. Therefore, the content of oxygen element in the microcrystalline silicon doped conductive layer 203 cannot exceed a certain value. The content of oxygen element in the microcrystalline silicon doped conductive layer 203 controls the band gap width of the conductive layer and the doping concentration of impurities. On the one hand, in order to reduce the absorption of light in the conductive layer and increase the band gap of the material, higher oxygen content is needed; on the other hand, in order to improve the conductivity of the conductive layer and increase the content of doped impurities in the conductive layer, it is needed to reduce the oxygen content in the conductive layer.

Embodiments of the present disclosure provide a solar cell unit including a microcrystalline silicon doped conductive layer. The microcrystalline silicon doped conductive layer is doped with a doping element to make the conductive layer have excellent conductive properties, and the conductive layer also includes carbon element and oxygen element to make the conductive layer have a higher band gap and lower light absorption rate. As illustrated by Fig. 3, the content of carbon element in the conductive layer has little effect on the content of doping elements. By increasing carbon element and adjusting the ratio of carbon element to oxygen element, the band gap width can be increased and the absorption of light can be reduced, while avoiding the reduction of doping element concentration in the conductive layer due to too high oxygen content.

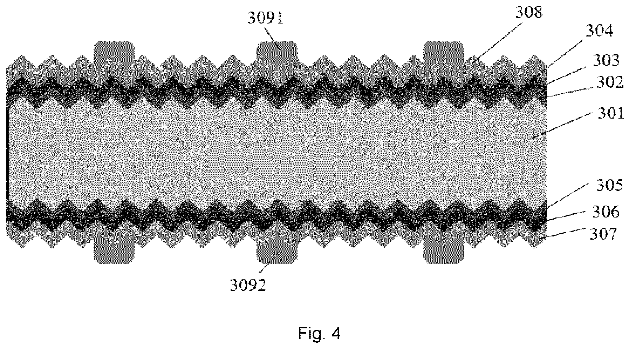

Fig. 4 shows a schematic diagram of a solar cell unit according to an embodiment of the present disclosure. As illustrated by Fig. 4, the solar cell unit includes a silicon substrate 301, a first passivation layer 302 arranged on a first side of the silicon substrate 301, a first doped conductive layer 303 arranged on the first passivation layer 302, a second doped conductive layer 304 arranged on the first doped conductive layer 303, a first transparent conductive layer 308 arranged on the second doped conductive layer 304, a first electrode 3091 arranged on the first transparent conductive layer 308, a second passivation layer 305 disposed on a second side of the silicon substrate 301, a third doped conductive layer 306 disposed on the second passivation layer 305, a second transparent conductive layer 307 disposed on the third doped conductive layer 306, and a second electrode 3092 disposed on the second transparent conductive layer 307. The first side is a light receiving side of the solar cell unit.

The silicon substrate 301 is an n-type silicon substrate 301. The first passivation layer 302 and the second passivation layer 305 are intrinsic hydrogenated amorphous silicon layers. The first doped conductive layer 303 is a hydrogenated microcrystalline silicon doped conductive layer doped with phosphorus atoms and includes Si-O chemical bonds and Si-C chemical bonds. The second doped conductive layer 304 is a hydrogenated amorphous silicon doped conductive layer doped with phosphorus atoms and basically does not include Si-O chemical bonds and Si-C chemical bonds. The third doped conductive layer 306 is a hydrogenated amorphous silicon doped conductive layer doped with boron. The first transparent conductive layer 308 and the second transparent conductive layer 307 are ITO layers. The first electrode 3091 and the second electrode 3092 are silver electrodes.

In the first doped conductive layer 303, Si-Si chemical bonds, Si-O chemical bonds and Si-C chemical bonds act as the conductive layer network formers, hydrogen element acts as the network modifier to passivate the dangling bonds in the saturated conductive layer, and phosphorus atom acts as the doping element to make the conductive layer have excellent conductivity. The conductive layer has a wide band gap (Eg=1.9-2.4eV, for example) and good carrier conduction ability. For example, the thickness of the first doped conductive layer 303 is in the range of 6-14 nm.

Because the first doped conductive layer 303 includes Si-O chemical bonds and SiC chemical bonds, the introduction of carbon element avoids the decrease of doping element concentration in the conductive layer due to too high oxygen content, and realizes a conductive layer with high band gap and low light absorption rate and excellent conductivity.

The total content of the carbon element and the oxygen element in the first doped conductive layer 303 may be in the range of 20-30%. The molar content ratio of carbon element can be in the range of 3-15%. The molar content of oxygen element can be in the range of 10-30%. Increasing the total content of the carbon element and the oxygen element in the conductive layer can increase the band gap of the conductive layer and reduce the absorption of incident light. Maintaining the total content of the carbon element and the oxygen element in the conductive layer, increasing the carbon content in the conductive layer and reducing the oxygen content in the conductive layer can increase the phosphorus doping concentration in the conductive layer.

The carbon element can exist by forming the Si-C chemical bond, a C-C chemical bond, a C-O chemical bond and a C-H chemical bond, and molar content ratios of these chemical bonds in the total carbon content can be in the range of 40-60%, 30-50%, 5-18% and 2-10%, respectively.

The oxygen element can exist by forming the Si-O chemical bond, a C-O chemical bond and a P-O chemical bond, and the molar content ratios of these chemical bonds in the total oxygen content are 70-90%, 6-18% and 2-10%, respectively.

The contents of carbon element, oxygen element and silicon element in the first doped conductive layer 303 may be gradually changed. For example, in a direction toward the silicon substrate 301, the molar content of the carbon element in the first doped conductive layer 303 may gradually decrease, the molar content of oxygen element in the first doped conductive layer 303 may gradually increase, and the molar content of doping elements in the first doped conductive layer 303 may gradually decrease. For example, the content of phosphorus element in the first doped conductive layer 303 may be in the range of 2×1018-3×1021 atoms per cubic centimeter.

Here, the microcrystalline silicon doped conductive layer refers to a silicon conductive layer in which at least a part of the silicon component is crystallized. For example, at least a part of the silicon component of the first doped conductive layer 303 is crystallized, and its crystallization rate may be in the range of 40-70%. In the direction toward the silicon substrate 301, the crystallization rate of the first doped conductive layer 303 may gradually decrease. In the present embodiment, the first doped conductive layer 303 is a hydrogenated amorphous silicon layer in which crystallized silicon is embedded.

The second doped conductive layer 304 may be an amorphous conductive layer doped with high concentration of phosphorus. The second doped conductive layer 304 has good coverage to the first doped conductive layer 303, which can avoid the decrease of phosphorus atom concentration caused by the subsequent high temperature process.

Furthermore, the present disclosure is not limited thereto. The silicon substrate 301 may be a p-type silicon substrate 301. The first passivation layer and/or the second passivation layer 305 may be other types of passivation layers. For example, the first passivation layer 302 and the second passivation layer 305 may be composed of passivation laminations, and an amorphous silicon layer and a silicon hydride layer may be sequentially arranged in a direction away from the silicon substrate 301. The first doped conductive layer 303 may be a hydrogenated microcrystalline silicon doped conductive layer doped with boron atoms and includes Si-O chemical bonds and Si-C chemical bonds. In addition, the second doped conductive layer 304 may be omitted. In addition, the third doped conductive layer 306 may be a hydrogenated microcrystalline silicon doped conductive layer similar to the first doped conductive layer 303 and includes Si-O chemical bonds and Si-C chemical bonds, which is particularly advantageous when the second side is also the light receiving side of the solar cell unit.

Embodiments of the present disclosure provide a manufacturing method of a solar cell unit, which can be used to manufacture the solar cell unit as described above. The method comprises the following steps:
Step S11, providing a silicon substrate 301.
Step S12, forming a first passivation layer 302 and a second passivation layer 305 respectively on two opposite surfaces of the silicon substrate 301.
Step S13, forming a first doped conductive layer 303 on the first passivation layer 302 on a first side of the silicon substrate 301 by using oxygen-containing reaction gas and carbon-containing reaction gas, so that the first doped conductive layer includes Si-O chemical bonds and Si-C chemical bonds.
Step S14, forming a second doped conductive layer 304 on the first doped conductive layer 303 of the silicon substrate 301.
Step S15, forming a third doped conductive layer 306 on the second passivation layer 305 on a second side of the silicon substrate 301.
Step S16, forming transparent conductive layers on the first doped conductive layer 303 and the third doped conductive layer 306, respectively.
Step S17, forming electrodes, such as silver electrodes, on the transparent conductive layers on both sides, respectively.

In step S13, the oxygen-containing reaction gas may be one or more selected from the group consisting of N2O, O2, CO2 and CO, and the carbon-containing reaction gas may be one or more selected from the group consisting of CH4, C2H6, C3H10 and C2H4. In addition, phosphine gas can also be used, so that the first doped conductive layer is doped with phosphorus element. More specifically, PH3 gas and SiH4 gas may be used, and the flow ratio of PH3 gas and SiH4 gas may be 0.02-0.1 to at least partially crystallize the formed hydrogenated amorphous silicon layer.

In an example, the first doped conductive layer is formed by PECVD process, in which a radio frequency power supply (RF) or a very high frequency power supply (VHF) is used as a plasma excitation source, the energy density of the ion source is 100-600mW/cm2, the deposition pressure is 0.4-5Torr, and the deposition temperature is 130-230 °C.

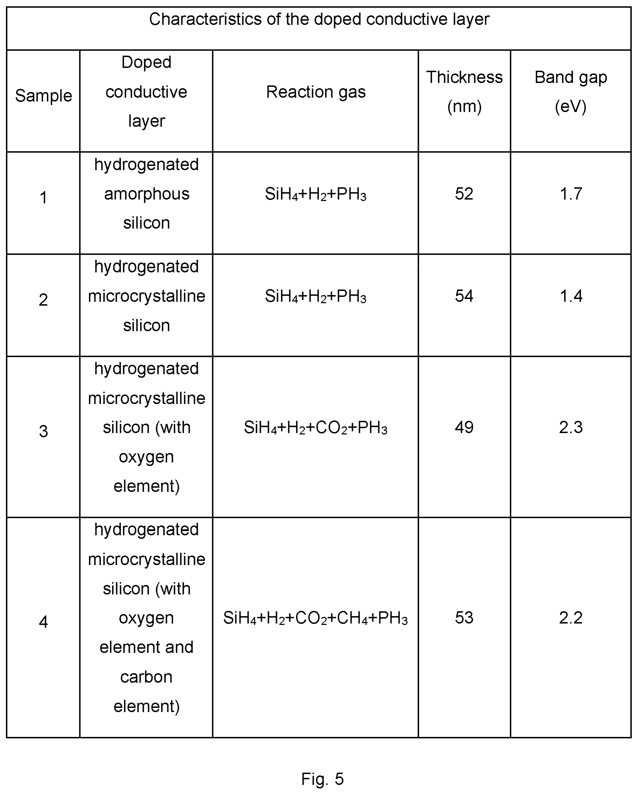

Fig. 5 shows the values of the thickness and band gap width of four samples of doped conductive layers formed with different reaction gases. Each sample is formed on a polished silicon substrate by PECVD process. The reaction conditions of sample 1 are provided as follows: the deposition pressure (i.e. the pressure in the reaction chamber where the sample is deposited) is 133pa, the RF power is 2000W, the reaction gases are SiH4, H2 and PH3, the flow rates are 2000sccm, 2000sccm and 200sccm respectively, and the deposition time is 8min. The reaction conditions of sample 2 are provided as follows: the deposition pressure is 153pa, the RF power is 4000W, the reaction gases are SiH4, H2 and PH3, the flow rates are 1000sccm, 50SLM and 100sccm respectively, and the deposition time is 15min. The reaction conditions of sample 3 are provided as follows: the deposition pressure is 163pa, the RF power is 4500W, the reaction gases are SiH4, H2, PH3 and CO2, the flow rates are 1000sccm, 50SLM, 100sccm and 2000sccm respectively, and the deposition time is 15min. The reaction conditions of sample 4 are provided as follows: the deposition pressure is 183pa, the RF power is 5000W, the reaction gases are SiH4, H2, PH3, CH4 and CO2, the flow rates are 1000sccm, 50SLM, 100sccm, 500sccm and 1000sccm respectively, and the deposition time is 15min.

As can be seen from Fig. 5, samples 3 and 4 have relatively wide band gaps.

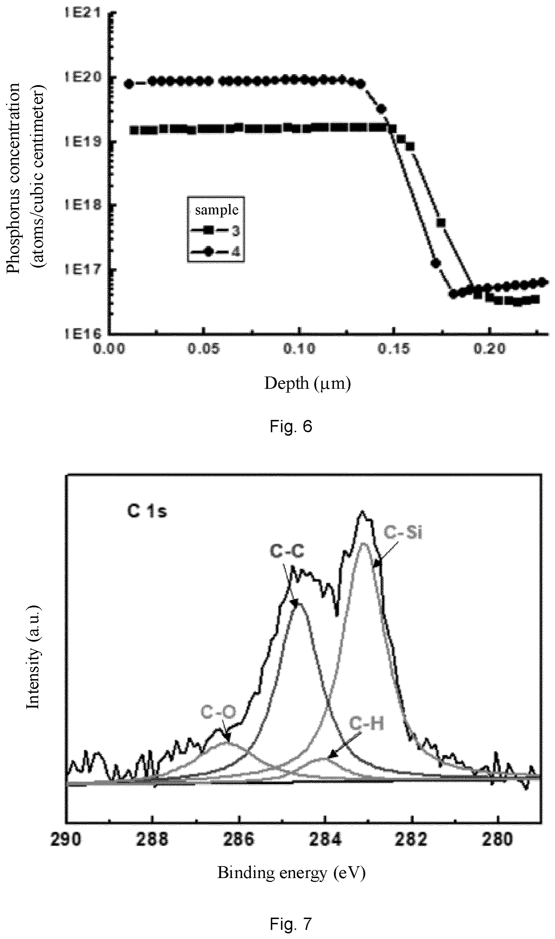

Fig. 6 shows the phosphorus doping concentrations in samples 3 and 4 in Fig. 5. As illustrated by Fig. 6, at the doping depth of 0 to about 0.13 micron, the doping concentration of sample 4 is about 1×1020 atoms/cm3, and doping concentration of sample 3 is about 1×1019 atoms/cm3. Sample 4 has a higher concentration of phosphorus doping than sample 3.

The performance of solar cell units according to a comparative example 1, a comparative example 2 and three embodiments (embodiment 1, embodiment 2 and embodiment 3) of the present disclosure will be compared below.

The solar cell unit according to the comparative example 1 is prepared by the following steps:
Step S21, providing a silicon substrate. The silicon substrate is a monocrystalline n-type silicon substrate, and its bulk resistivity is 3.5Ω•cm.
Step S22, performing a surface texturing treatment on the silicon substrate. Specifically, the silicon substrate is anisotropically etched with 5% sodium hydroxide alkali solution, and a textured silicon substrate surface is obtained, and its reflectivity is not more than 12%.
Step S23, forming a first passivation layer and a second passivation layer respectively on two opposite surfaces of the silicon substrate. Specifically, a hydrogenated amorphous silicon layer with a thickness of 10 nm is formed as the first passivation layer and the second passivation layer on two opposite surfaces of a silicon substrate by PECVD process. The pseudo-open circuit voltage of the silicon substrate after double-sided passivation reaches 750 mV.
Step S24, forming a phosphorus-doped hydrogenated amorphous silicon layer as a first doped conductive layer on the first passivation layer on the first side of the silicon substrate. Specifically, a phosphorus-doped hydrogenated amorphous silicon layer is deposited on a hydrogenated amorphous silicon layer on a side of a silicon substrate by using a PECVD process by using a reaction gas consisting of SiH4, H2 and PH3. The thickness of the phosphorus-doped hydrogenated amorphous silicon layer is 15 nm.
Step S25, forming a boron-doped hydrogenated amorphous silicon layer as a third doped conductive layer on the second passivation layer on a second side of the silicon substrate. Specifically, a boron-doped hydrogenated amorphous silicon layer is deposited on a surface of a hydrogenated amorphous silicon film on the other side of the silicon substrate by using a PECVD process by using a reaction gas composed of SiH4, H2 and B2H6. The thickness of the boron-doped hydrogenated amorphous silicon layer is 15 nm.
Step S26: Using PVD equipment to deposit ITO transparent conductive film layers with a thickness of 80 nm on the phosphorus-doped hydrogenated amorphous silicon layer and the boron-doped hydrogenated amorphous silicon layer on both sides of the silicon substrate, respectively.
Step S27: forming silver electrodes by printing and curing low-temperature silver paste at 255 °C on the ITO transparent conductive film layers on both sides of the silicon substrate.

The solar cell unit according to the comparative example 2 is prepared similarly to the solar cell unit according to the comparative example 1, except for step S24. In the preparation process of the solar cell unit according to the comparative example 2, in step S24, a phosphorus-doped hydrogenated microcrystalline silicon layer is deposited on the hydrogenated amorphous silicon layer on a side of the silicon substrate by PECVD process using a reaction gas composed of SiH4, H2 and PH3, as a first doped conductive layer. In this step, the chamber pressure is set to 153pa, the RF power is set to 4000W, and 1000sccm SiH4, 50 SLM H2 and 100sccm PH3 are introduced. The thickness of the phosphorus-doped hydrogenated microcrystalline silicon layer is 15 nm. Then, a phosphorus-doped hydrogenated amorphous silicon layer is deposited on the phosphorus-doped hydrogenated microcrystalline silicon layer as an additional second doped conductive layer by PECVD using a reaction gas consisting of SiH4, H2 and PH3. The thickness of the phosphorus-doped hydrogenated amorphous silicon layer is 3 nm.

The solar cell unit according to the embodiment 1 is prepared similarly to the solar cell unit according to the comparative example 1, except for step S24. In the preparation process of preparing the solar cell unit according to the embodiment, in step S24, a phosphorus-doped hydrogenated microcrystalline carbon silicon oxide layer is deposited as a first doped conductive layer on a first passivation layer on a side of a silicon substrate by using a PECVD process using a reaction gas composed of SiH4, H2, CO2, CH4 and PH3. The thickness of the phosphorus-doped hydrogenated microcrystalline silicon carbide oxide layer is 15 nm. Then, a phosphorus-doped hydrogenated amorphous silicon layer is deposited on the hydrogenated microcrystalline carbon silicon oxide layer as an additional second doped conductive layer by PECVD using a reaction gas consisting of SiH4, H2 and PH3. The thickness of the phosphorus-doped hydrogenated amorphous silicon layer is 3 nm.

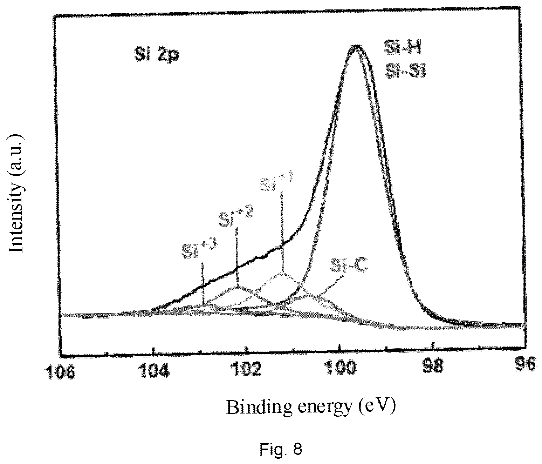

Figs. 7 and 8 respectively show the results of X-ray photoelectron spectroscopy analysis of carbon element and silicon element in a first doped conductive layer of the solar cell unit according to an embodiment 1. As illustrated by Figs. 7 and 8, the first doped conductive layer includes carbon element, silicon element and oxygen element, and the oxygen element and a part of the carbon element form Si-O chemical bonds and Si-C chemical bonds.

The solar cell unit according to the embodiment 2 is prepared similarly to the solar cell unit according to the embodiment 1, and the only difference is step S24. In the preparation process of preparing the solar cell unit according to the embodiment, in step S24, a phosphorus-doped hydrogenated microcrystalline carbon silicon oxide layer is deposited as a first doped conductive layer on a first passivation layer on a side of a silicon substrate by using a PECVD process using a reaction gas composed of SiH4, H2, CO2, CH4 and PH3, and the flow ratio of CH4 and SiH4 is gradually increased from 0.05 to 1.5 from an inner side position close to the silicon substrate to an outer side position away from the silicon substrate, while the flow ratio of CO2 and SiH4 is gradually decreased from 1.5 to 0.5, so as to form the first doped conductive layer with the total content of carbon element and oxygen element unchanged, but the content of the carbon element gradually increases and the content of the oxygen element gradually decreases in the direction away from the silicon substrate. The thickness of the phosphorus-doped hydrogenated microcrystalline silicon carbide oxide layer is 15 nm. Then, a phosphorus-doped hydrogenated amorphous silicon layer is deposited on the hydrogenated microcrystalline carbon silicon oxide layer as an additional second doped conductive layer by PECVD using a reaction gas consisting of SiH4, H2 and PH3. The thickness of the phosphorus-doped hydrogenated amorphous silicon layer is 3 nm.

The solar cell unit according to the embodiment 3 is prepared similarly to the solar cell unit according to the embodiment 1, except for step S24. In the preparation process of preparing the solar cell unit according to the embodiment 3, in step S24, a phosphorus-doped hydrogenated microcrystalline carbon silicon oxide layer is deposited as a first doped conductive layer on the first passivation layer on a side of the silicon substrate by PECVD process using a reaction gas composed of SiH4, H2, CO2, CH4 and PH3. The thickness of the phosphorus-doped hydrogenated microcrystalline silicon carbide oxide layer is 15 nm. However, in the solar cell unit according to the embodiment 3, a phosphorus-doped hydrogenated amorphous silicon layer is not deposited on the hydrogenated microcrystalline carbon silicon oxide layer as an additional second doped conductive layer.

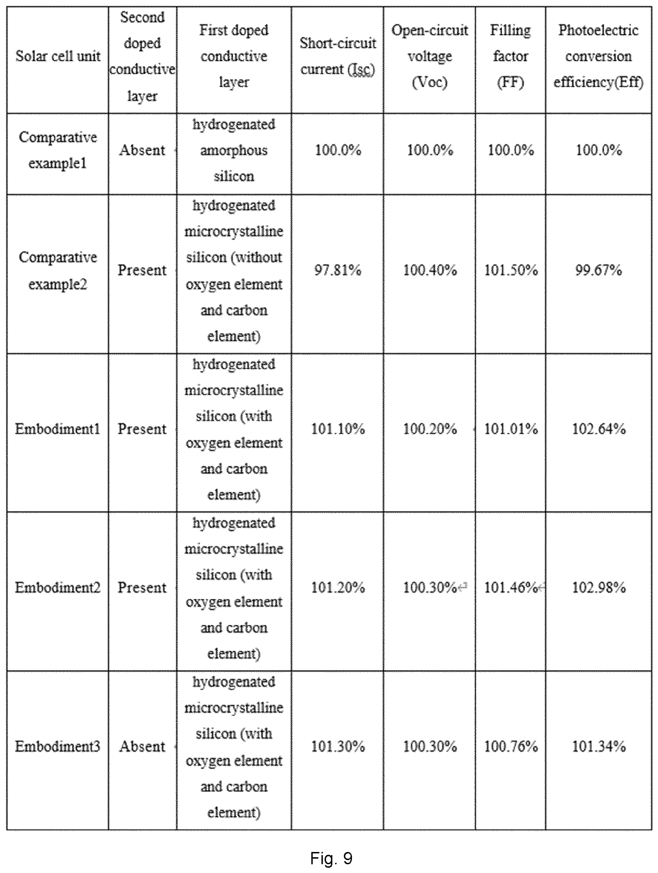

Fig. 9 shows a performance comparison of solar cell units according to a comparative example 1, a comparative example 2, an embodiment 1, an embodiment 2 and an embodiment 3. As illustrated by Fig. 9, in the case where the short-circuit current, open-circuit voltage, filling factor and photoelectric conversion efficiency of the solar cell unit according to the comparative example 1 are 100% respectively, the short-circuit current, open-circuit voltage, filling factor and photoelectric conversion efficiency of the solar cell unit according to the comparative example 2 are 97.81%, 100.40%, 101.501% and 99.67% respectively, the short-circuit current, open-circuit voltage, filling factor and photoelectric conversion efficiency of the solar cell unit according to the embodiment 1 are 101.10%, 100.20%, 101.01% and 102.64%, respectively, the short-circuit current, open-circuit voltage, filling factor and photoelectric conversion efficiency of the solar cell unit according to the embodiment 2 are 101.20%, 100.30% and 101.46%, and 102.98%, respectively, and the short-circuit current, open-circuit voltage, filling factor and photoelectric conversion efficiency of the solar cell unit according to the embodiment 3 are 101.30%, 100.30%, 100.76% and 101.34%, respectively. Compared with the solar cell unit of the comparative example 1, the solar cell unit of the comparative example 2 having higher open-circuit voltage and filling factor, but lower short-circuit current and photoelectric conversion efficiency. In the comparative example 2, the concentration of active phosphorus atoms in the first doped conductive layer is improved because carbon element and oxygen element are not doped in the first doped conductive layer, so the passivation performance and filling factor are improved, but the band gap of the phosphorus doped microcrystalline silicon film layer is small, which absorbs the light in a larger band, so the short-circuit current is reduced. For the heterojunction cell as a battery with excellent passivation, the current plays a decisive role in the photoelectric conversion efficiency of the battery. As can be seen from Fig. 9, it is difficult to improve the battery efficiency simply by microcrystallization. Therefore, it is needed to further dope carbon element and oxygen element into the first doped conductive layer to increase the band gap value of the microcrystalline film layer. Compared with the solar cell unit according to the comparative example 1, the solar cell units of embodiments 1-3 have higher short-circuit current, open-circuit voltage, filling factor and photoelectric conversion efficiency. And compared with the solar cell unit according to the comparative example 2, the solar cell unit of embodiments 1-3 has higher short-circuit current and photoelectric conversion efficiency. Therefore, compared with the phosphorus-doped hydrogenated amorphous silicon layer or phosphorus-doped hydrogenated microcrystalline silicon layer without Si-O chemical bonds and Si-C chemical bonds as the first doped conductive layer, the phosphorus-doped hydrogenated microcrystalline carbon silicon oxide layer with Si-O chemical bonds and Si-C chemical bonds as the first doped conductive layer is beneficial to improve the performance of battery cells. Compared with the solar cell unit according to the embodiment 1, the solar cell unit according to the embodiment 2 has higher short-circuit current, open-circuit voltage, filling factor and photoelectric conversion efficiency. Therefore, the first doped conductive layer with increasing carbon content and decreasing oxygen content in the direction away from the silicon substrate is beneficial to improve the performance of the battery cell. Compared with the solar cell unit according to the embodiment 3, the solar cell unit according to embodiment 1 has higher photoelectric conversion efficiency. Therefore, the formation of the second doped conductive layer is beneficial to improve the performance of the battery cell.

The scope of the present disclosure is defined not by the above-described embodiments, but by the appended claims and their equivalents.

## Claims

1. A solar cell unit, comprising:
a silicon substrate;
a first passivation layer, disposed on a first side of the silicon substrate; and
a first doped conductive layer, disposed on the first passivation layer so that the first passivation layer is located between the silicon substrate and the first doped conductive layer,
wherein the first doped conductive layer comprises carbon element and oxygen element, and comprises a Si-O chemical bond and a Si-C chemical bond.

2. The solar cell unit according to claim 1, wherein,
a total molar content of the carbon element and the oxygen element is 20-30%.

3. The solar cell unit according to claim 1 or 2, wherein,
the first doped conductive layer comprises silicon element, oxygen element, carbon element, and hydrogen element, and a molar content ratio of the carbon element is 3-15%.

4. The solar cell unit according to any one of claims 1 to 3, wherein,
the carbon element exists by forming the Si-C chemical bond, a C-C chemical bond, a C-O chemical bond and a C-H chemical bond, and molar content ratios of the Si-C chemical bond, the C-C chemical bond, the C-O chemical bond and the C-H chemical bond in a total carbon content are 40-60%, 30-50%, 5-18% and 2-10%, respectively.

5. The solar cell unit according to any one of claims 1 to 4, wherein,
the first doped conductive layer comprises silicon element, oxygen element, carbon element and hydrogen element, and a molar content ratio of the oxygen element is 10-30%.

6. The solar cell unit according to any one of claims 1 to 5, wherein,
the oxygen element exists by forming the Si-O chemical bond, a C-O chemical bond and a P-O chemical bond, and molar content ratios of the Si-O chemical bond, the C-O chemical bond and the P-O chemical bond in the total oxygen content are 70-90%, 6-18% and 2-10%, respectively.

7. The solar cell unit according to any one of claims 1 to 6, wherein,
a band gap width of the first doped conductive layer is in a range of 1.9-2.4 eV.

8. The solar cell unit according to any one of claims 1 to 7, wherein,
a thickness of the first doped conductive layer is in a range of 6-14 nm.

9. The solar cell unit according to any one of claims 1 to 8, wherein,
in a direction toward the silicon substrate, a molar content of the carbon element in the first doped conductive layer gradually decreases, a molar content of the oxygen element in the first doped conductive layer gradually increases, and a molar content of a doping element in the first doped conductive layer gradually decreases.

10. The solar cell unit according to any one of claims 1 to 9, wherein,
a content of a doping element in the first doped conductive layer is in a range of 2×10¹⁸-3×10²¹ atoms per cubic centimeter.

11. The solar cell unit according to any one of claims 1 to 10, wherein,
at least a part of a silicon component of the first doped conductive layer is crystallized.

12. The solar cell unit according to claim 11, wherein,
a crystallization rate of the first doped conductive layer is in a range of 40-70%.

13. The solar cell unit according to claim 12, wherein,
the first doped conductive layer is a hydrogenated amorphous silicon layer in which crystallized silicon is embedded.

14. The solar cell unit according to any one of claims 11 to 13, wherein,
in a direction toward the silicon substrate, a crystallization rate of the first doped conductive layer gradually decreases.

15. The solar cell unit according to any one of claims 1 to 14, wherein,
the first doped conductive layer is an n-type conductive layer and comprises silicon element, oxygen element, carbon element, hydrogen element and phosphorus element.

16. The solar cell unit according to claim 15, wherein,
the silicon substrate is an n-type silicon substrate.

17. The solar cell unit according to any one of claims 1 to 5 and 7 to 14, wherein,
the first doped conductive layer is a p-type conductive layer and comprises silicon element, oxygen element, carbon element, hydrogen element and boron element.

18. The solar cell unit according to any one of claims 1 to 17, further comprising
a second doped conductive layer disposed on the first doped conductive layer such that the first doped conductive layer is located between the first passivation layer and the second doped conductive layer.

19. The solar cell unit according to claim 18, wherein,
a content of a doping element in the second doped conductive layer is in a range of 10¹⁹-10²¹ atoms per cubic centimeter.

20. The solar cell unit according to any one of claims 1 to 19, further comprising
a second passivation layer, disposed on a second side of the silicon substrate; and
a third doped conductive layer, disposed on the second passivation layer so that the second passivation layer is located between the silicon substrate and the third doped conductive layer,
wherein at least the first side is a light receiving side.

21. A manufacturing method of a solar cell unit, comprising:
providing a silicon substrate;
forming a first passivation layer on a first side of the silicon substrate; and
forming a first doped conductive layer on the first passivation layer so that the first passivation layer is located between the silicon substrate and the first doped conductive layer,
wherein, when forming the first doped conductive layer, oxygen-containing reaction gas and carbon-containing reaction gas are used, so that the first doped conductive layer comprises a Si-O chemical bond and a Si-C chemical bond.

22. The manufacturing method according to claim 21, wherein,
the oxygen-containing reaction gas is one or more selected from a group consisting of N₂O, O₂, CO₂ and CO.

23. The manufacturing method according to claim 21 or 22, wherein,
the carbon-containing reaction gas is one or more selected from a group consisting of CH₄, C₂H₆, C₃H₁₀ and C₂H₄.

24. The manufacturing method according to any one of claims 21 to 23, wherein,
when forming first doped conductive layer, phosphine gas is used, so that the first doped conductive layer is doped with phosphorus.

25. The manufacturing method according to any one of claims 21 to 24, wherein,
when forming the first doped conductive layer, PH₃ gas and SiH₄ gas are used, and a flow ratio of the PH₃ gas and the SiH₄ gas is 0.02-0.1.

26. The manufacturing method according to any one of claims 21 to 25, wherein,
forming the first doped conductive layer by using a plasma enhanced chemical vapor deposition method, wherein a radio frequency power supply or a very high frequency power supply is used as a plasma excitation source, an energy density of an ion source is 100-600mW/cm², a deposition pressure is 0.4-5Torr, and a deposition temperature is 130-230 ^{O}C.
